Europäisches Patentamt

European Patent Office

Office européen des brevets

(19)

(11) Numéro de publication: **0 338 636**
**A1**

(12) **DEMANDE DE BREVET EUROPEEN**

(21) Numéro de dépôt: 89200973.9

(22) Date de dépôt: 17.04.89

(51) Int. Cl.4: **H01L 21/60 , H01L 21/90 , H01L 23/50**

(30) Priorité: 22.04.88 FR 8805375

(43) Date de publication de la demande:
**25.10.89 Bulletin 89/43**

(84) Etats contractants désignés:
**DE FR GB IT NL**

(71) Demandeur: **N.V. Philips' Gloeilampenfabrieken Groenewoudseweg 1 NL-5621 BA Eindhoven(NL)**

(72) Inventeur: **Doan, Trung c/o INT. OCTROOIBUREAU B.V. Prof. Holstlaan 6 NL-5656 AA Eindhoven(NL)**
Inventeur: **De Bruin, Leendert c/o INT. OCTROOIBUREAU B.V. Prof. Holstlaan 6 NL-5656 AA Eindhoven(NL)**
Inventeur: **Grief, Malcolm c/o INT. OCTROOIBUREAU B.V. Prof. Holstlaan 6 NL-5656 AA Eindhoven(NL)**
Inventeur: **Godon, Harald c/o INT. OCTROOIBUREAU B.V. Prof. Holstlaan 6 NL-5656 AA Eindhoven(NL)**

(74) Mandataire: **Pinchon, Pierre et al Société Civile S.P.I.D. 209 rue de l'Université F-75007 Paris(FR)**

(54) **Procédé pour établir des contacts électriques de petites dimensions sur un dispositif semiconducteur.**

(57) - Procédé du type consistant à obtenir un contact avec une zone active (11) portée par un substrat semiconducteur (10) au moyen de plots conducteurs (15a, 14a) localisés dans les ouvertures de contact (13) formées dans une couche isolante (12), et à réaliser ensuite une configuration d'interconnexion (20) métallique qui recouvre les plots conducteurs (15a, 14a).

- On intercale entre les première (14) et seconde (15), couches conductrices qui servent à former les plots conducteurs, une couche de séparation (16) faite en un matériau conducteur qui peut être décapé sélectivement par rapport au matériau de la seconde couche conductrice (15).

Ainsi, les plots conducteurs (15a, 14a) peuvent être réalisés de sorte que leur niveau supérieur dépasse légèrement la surface de la couche isolante (12). De préférence la couche de séparation (16) forme également un arrêt de décapage lors de l'élimination de la seconde couche conductrice (15).

- Application aux micro-circuits à haute densité d'intégration.

FIG.1

FIG. 4

# PROCEDE POUR ETABLIR DES CONTACTS ELECTRIQUES DE PETITES DIMENSIONS, SUR UN DISPOSITIF SEMICONDUCTEUR.

La présente invention concerne un procédé pour établir un contact électrique de petites dimensions sur un dispositif semiconducteur utilisant la technique des plots de contact localisés dans des ouvertures gravées dans une couche isolante. Elle trouve une application particulièrement avantageuse dans le domaine des circuits monolithiques à forte densité d'intégration.

La technologie des semiconducteurs montre une évolution très marquée en faveur d'une intégration d'un nombre toujours plus élevé de composants élémentaires dans un même circuit monolithique.

Pour parvenir à cet objectif et parallèlement en vue d'augmenter la rapidité de fonctionnement des circuits, on est amené à réduire autant que possible les dimensions des composants élémentaires et de ce fait, à réduire aussi la surface de contact avec les zones actives de ces composants.

Il est également nécessaire de pouvoir réaliser une structure métallique d'interconnexion dont les lignes conductrices soient étroites mais cependant relativement épaisses pour assurer une faible résistance avec un encombrement minimal, et que cette structure soit supportée par une couche isolante assez épaisse pour que la capacité parasite de ces lignes par rapport au substrat semiconducteur reste aussi faible que possible.

L'expérience montre que les techniques classiques de prise de contact deviennent inapplicables lorsqu'on cherche à utiliser des ouvertures de contact dans la couche isolante qui aient un rapport profondeur/diamètre, encore appelé rapport d'aspect, présentant une valeur qui s'approche de l'unité ou qui est plus élevée.

Une couche d'aluminium ou d'alliage d'aluminium par exemple, obtenue par évaporation sous vide, n'a pas un pouvoir couvrant suffisant pour franchir la discontinuité présentée par le bord nécessairement abrupt des ouvertures de contact et, lorsque le rapport d'aspect de ces ouvertures est proche de 1, on observe que le dépôt d'une couche d'aluminium aboutit à l'obstruction de l'entrée des ouvertures de contact alors que le fond et les parois de ces ouvertures ne sont pas recouverts d'une couche regulière de métal.

Une solution pour résoudre cette difficulté est connue par le document EP-A-245 627 qui propose d'établir un contact électrique de petites dimensions sur un circuit semiconducteur du genre VLSI, au moyen d'un plot de contact localisé dans la cavité constituée par l'ouverture de contact percée dans la couche isolante.

Selon le procédé connu, après avoir gravé les ouvertures de contact dans la couche isolante, on dépose une première couche conductrice, par exemple en alliage tungstène-silicium, en utilisant une méthode à fort pouvoir couvrant de toute la surface y compris de la surface intérieure des ouvertures de contact. Cette première couche conductrice est relativement mince par rapport au diamètre des ouvertures de contact et donc elle ne réalise pas un remplissage de ces ouvertures. Elle est choisie pour adhérer sur le matériau de la couche isolante ainsi que sur les zones de contact du semiconducteur, dans les ouvertures de contact, et pour y établir un contact à faible résistance. Cette opération est suivie du dépôt d'une seconde couche conductrice, en utilisant également une méthode de dépôt à fort pouvoir couvrant, cette seconde couche conductrice étant suffisamment épaisse pour assurer le remplissage des ouvertures de contact. Après cela, les couches conductrices sont retirées de la surface de la couche isolante mais en maintenant du matériau conducteur de ces couches dans les ouvertures de contact où sont formés des plots de contact localisés.

Une configuration d'interconnexion peut ensuite être réalisée par le dépôt d'une couche métallique, par exemple en alliage d'aluminium, qui est gravée à la forme désirée et établit les liaisons électriques nécessaires entre les plots de contact.

En pratique, on observe généralement que la surface supérieure de la seconde couche conductrice présente une certaine dépression à l'aplomb des ouvertures de contact, qui a pour origine la consommation de matériau correspondant au remplissage de la cavité de l'ouverture de contact. Si on retirait de manière uniforme les deux couches conductrices pour dégager la surface de la couche isolante, on obtiendrait des plots de contact présentant une dépression similaire de leur niveau supérieur. Pour être sûr de dégager complètement la surface de la couche isolante de tous les résidus de matériau conducteur, il est nécessaire de prolonger quelque peu l'attaque des couches conductrices. Ceci peut avoir pour conséquence d'abaisser encore le niveau supérieur des plots de contact par rapport au niveau de la couche isolante, lorsque cette dernière n'est pas attaquée dans les conditions de décapage utilisées, ou si elle est attaquée à faible vitesse.

Or l'expérience à montré que pour une bonne qualité du contact entre les plots de contact et la couche métallique qui les recouvre ultérieurement il est essentiel d'assurer que la surface supérieure des plots de contact soit alignée avec le niveau de la couche isolante ou qu'elle dépasse légèrement ce niveau et il est important d'éviter en tout cas que les plots de contact soient en retrait à l'intérieur des ouvertures de contact.

Le procédé connu selon EP-A-245 627 propose une solution à ce problème par l'utilisation d'une couche supplémentaire en matière organique, dont l'attaque anisotrope et partielle fournit des îlots résiduels à l'emplacement des dépressions de la seconde couche conductrice, ces îlots résiduels étant ensuite utilisés comme masque pour la protection du matériau conducteur sous-jacent lors du décapage des deux couches conductrices.

Ce procédé présente l'inconvénient d'être entièrement basé sur la présence des dépressions et sur leur forme, alors que ces dépressions se produisent de manière involontaire et incontrôlée.

De plus, la réalisation des îlots résiduels de la couche de matière organique est obtenue par l'arrêt du décapage de cette couche à un moment qui doit être déterminé avec une très grande précision sinon la dimension de ces îlots sera modifiée dans le grandes proportions.

Aussi, le problème technique plus spécifique à résoudre par la présente invention est d'indiquer un procédé pour réaliser des contacts électriques de petites dimensions sur un dispositif semiconducteur, utilisant la technique des plots de contact conducteurs localisés dans des ouvertures de contacts d'une couche isolante, avec lequel on puisse obtenir de manière reproductible des plots de contact dont la surface supérieure affleure au moins le niveau de la surface de la couche isolante environnante, ou même dépasse légèrement ce niveau d'une hauteur déterminée, lorsqu'on le désire.

A cet effet, selon la présente invention un procédé pour établir des contacts électriques de petites dimensions sur un dispositif semiconducteur selon lequel, après avoir gravé des ouvertures de contact dans une couche isolante recouvrant le dispositif, on dépose successivement sur l'ensemble de la surface du dispositif et en utilisant une méthode assurant un fort pouvoir couvrant, une première couche conductrice relativement mince, pour former contact avec le corps semiconducteur et adhérer à la couche isolante, puis une seconde couche conductrice suffisamment épaisse pour compléter le remplissage des ouvertures de contact, après quoi on retire le matériau des couches conductrices pour dégager la surface de la couche isolante mais on le conserve dans les ouvertures de contact où il forme des plots de contact localisés qui sont ensuite reliés à une configuration d'interconnexion métallique dont on les recouvre, est caractérisé en ce qu'après avoir déposé la première couche conductrice on effectue le dépôt d'une couche dite de séparation, relativement mince, constituée d'un matériau conducteur qui peut être décapé sélectivement par rapport au matériau de la seconde couche conductrice, et en ce qu'on procède au décapage sélectif de la part essentielle de cette couche de séparation qui est située en dehors des ouvertures de contact lors de la phase ultérieure du procédé visant à dégager la surface de la couche isolante.

Par un choix judicieux de l'épaisseur de la couche dite de séparation, on créé effectivement une différence de niveau en faveur des plots de contact qui correspond à l'épaisseur de la couche de séparation qui est retirée sélectivement.

En fonction des conditions pratiques d'utilisation et notamment du temps de prolongation du décapage du matériau conducteur qui recouvre la couche de séparation on choisira une épaisseur plus ou moins importante de couche de séparation en vue d'obtenir des plots de contact plus ou moins proéminents au-dessus du niveau de la couche isolante.

L'invention présente l'avantage qu'après le décapage de la deuxième couche conductrice, d'éventuels résidus de cette couche sont facilement éliminés en même temps qu'on élimine la couche de séparation.

L'invention présente l'avantage supplémentaire que dans le cas où la surface de la deuxième couche conductrice présente une rugosité liée à la formation de micro cristaux dans cette couche de forte épaisseur, cette rugosité est absorbée par la couche de séparation et ne peut être transmise, par décapage, à la couche isolante. Ceci est dû au fait que la couche de séparation est éliminée de manière sélective par rapport au matériau de la première couche conductrice. En utilisant le procédé de l'art antérieur, on observe en effet fréquemment un transfert de la rugosité de surface de la deuxième couche conductrice vers la surface de la couche isolante du fait que l'attaque utilisée pour l'élimination des deux couches conductrices n'est pas suffisamment sélective vis-à-vis du matériau de la couche isolante. Cette rugosité de surface de la couche isolante entraîne à son tour de grosses difficultés dans la suite du procédé et notamment une réduction inacceptable de la résolution lors du photomasquage de la couche métallique servant à définir la configuration d'interconnexion.

Selon un premier mode de mise en oeuvre de l'invention, le procédé est caractérisé en ce que la couche de séparation est constituée d'un matériau choisi également pour résister au décapage effectué lors du retrait de la deuxième couche conductrice de manière à servir de couche d'arrêt lors de cette opération.

De cette manière, le décapage de la deuxième couche conductrice peut être pratiqué avec une plus grande reproductibilité notamment en ce qui concerne le choix du moment où on termine cette opération.

Selon un deuxième mode de mise en oeuvre, de l'invention, le procédé est caractérisé en ce qu'entre le dépôt de la couche de séparation et le dépôt de la seconde couche conductrice, on effectue en outre le dépôt d'une couche barrière, relativement mince, de même matériau que celui de la première couche conductrice, en ce que la couche de séparation est constituée d'un matériau choisi pour résister au décapage effectué lors du retrait de la couche barrière, de manière à servir de couche d'arrêt lors de cette opération. L'interposition d'une couche barrière entre la couche de séparation et la seconde couche conductrice rétablit une compatibilité totale dans la succession des couches déposées alors que le dépôt de la seconde couche conductrice peut présenter des inconvénients, dans certains cas, lorsqu'il est réalisé directement au-dessus de la couche de séparation.

Avantageusement on choisit l'aluminium, un alliage d'aluminium ou le cobalt pour constituer la couche de séparation tandis que la première couche conductrice est réalisée en un alliage riche en tungstène et la seconde couche conductrice, en tungstène.

La description qui va suivre, en regard des dessins annexés, donnés à titre d'exemples non limitatifs, fera bien comprendre comment l'invention peut être réalisée.

Les figures 1 à 4 représentent par des vues schématiques en coupe, les étapes principales du procédé selon un premier mode de mise en oeuvre de l'invention et,

les figures 5 à 7, des vues analogues illustrant un deuxième mode de mise en oeuvre de l'invention.

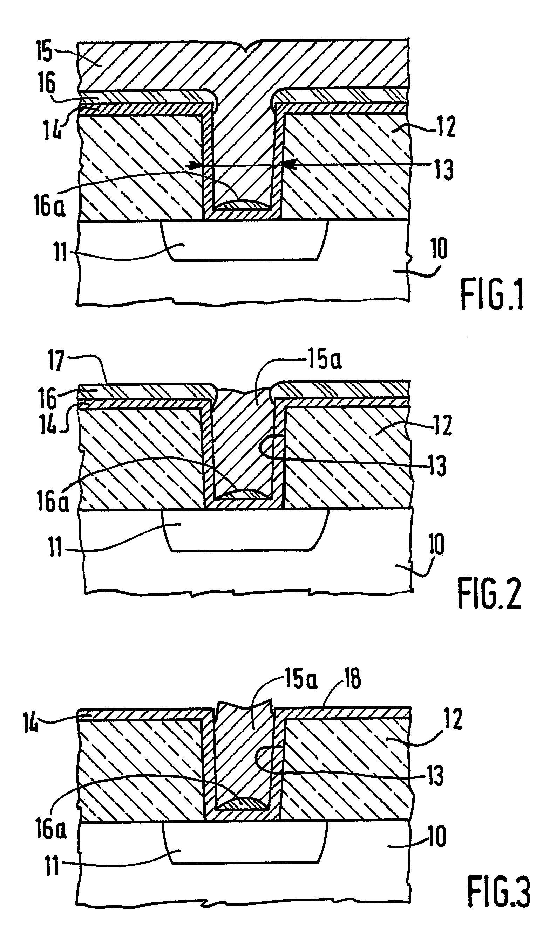

Le procédé selon l'invention concerne un procédé pour établir des contacts électriques de petites dimensions sur un dispositif semiconducteur dont une portion a été représentée schématiquement à la figure 1.

Dans un substrat 10 en silicium par exemple, ont été élaborés les différents éléments actifs d'un circuit intégré, les différentes étapes du procédé selon l'invention ayant pour but de prendre un contact électrique avec une région active 11 du dispositif qui peut être par exemple une région de source ou de drain d'un transistor à effet de champ de type MOS. Sur le substrat 10, on a formé une couche isolante 12, réalisée le plus souvent en verre de silice et qui peut être éventuellement dopée au phosphore ou au bore.

De manière à isoler convenablement la configuration d'interconnexion qui sera ultérieurement portée par la couche isolante 12 et également en vue de réduire le plus possible les capacités parasites, la couche isolante 12 présente une épaisseur relativement importante, de l'ordre de 0,8 à 1μm.

On grave ensuite des ouvertures de contacts 13 dans la couche isolante 12 dont le diamètre ou au moins l'une des dimensions latérales est très petite, c'est-à-dire du même ordre de grandeur que l'épaisseur de la couche isolante 12, voire même inférieure à cette épaisseur.

On dépose ensuite une première couche conductrice 14, relativement mince au moyen d'une méthode connue pour assurer un bon recouvrement de toute la surface du dispositif y compris la surface intérieure des ouvertures de contact 13. La nature de cette première couche conductrice est choisie de manière d'une part à assurer une bonne adhérence sur la couche isolante 12 et sur le matériau semiconducteur de la région active 11 et d'autre part pour assurer un bon contact avec cette région.

A titre d'exemple, la première couche conductrice peut être réalisée en tungstène, en alliage de tungstène-titane, ou en alliage tungstène-silicium. Cette première couche conductrice est relativement mince, c'est-à-dire qu'elle n'effectue pas le remplissage de l'ouverture de contact 13, son épaisseur étant une fraction seulement du diamètre des ouvertures de contacts. Une valeur appropriée de l'épaisseur de la première couche conductrice est de 100nm par exemple pour une ouverture de contact 13 d'un diamètre de 0,8μm.

Conformément au procédé selon l'invention, avant de déposer une seconde couche conductrice 15, on dépose d'abord une couche de séparation 16, relativement mince, constituée d'un matériau conducteur qui peut être décapé sélectivement par rapport au matériau de la seconde couche conductrice 15.

Comme on le verra par la suite, le rôle de la couche de séparation 16 s'exerce essentiellement dans les portions de surfaces qui sont situées en dehors des ouvertures de contacts 13. Ainsi il importe peu que la méthode utilisée pour le dépôt de la couche de séparation 16 assure ou non un fort pouvoir couvrant de la surface intérieure des ouvertures de contact.

Dans l'exemple représenté sur la figure 1, on a utilisé une méthode à faible pouvoir couvrant comme par exemple un dépôt physique en phase vapeur et la couche de séparation 16 n'a pas recouvert le bord abrupt de l'ouverture de contact 13 et n'a formé qu'un îlot détaché 16a dans le fond de cette ouverture. A titre de premier exemple, la couche de séparation 16 est réalisée par pulvérisation cathodique de cobalt d'une épaisseur nominale de 100 nm environ.

La seconde couche conductrice 15 est déposée à la suite. Elle est d'une épaisseur suffisante pour réaliser le remplissage des ouvertures de contacts 13. Dans notre exemple elle est réalisée en tungstène d'une épaisseur nominale de 1μm et elle est obtenue par la méthode connue de dépôt chimique en phase vapeur à pression réduite (LPCVD) utilisant la réduction par l'hydrogène de l'hexafluorure de tungstène ($WF_6$).

On retire ensuite la plus grande partie du matériau constituant la seconde couche conductrice 15 et on ne conserve ce matériau qu'à l'intérieur des ouvertures de contacts 13 ou il forme des plots de contacts localisés 15a.

Cette opération de décapage est réalisée au moyen d'un plasma d'hexafluorure de soufre ($SF_6$).

Cette étape du procédé est représentée à la figure 2. Dans l'exemple, la couche de séparation 16 en cobalt constitue une couche d'arrêt dans l'opération de décapage du tungstène. Comme cela est représenté à la figure 2, le niveau supérieure des plots de contacts 15a se trouvent légèrement en dessous du niveau 17 de la couche de séparation 16 du fait que le décapage de la seconde couche conductrice est poursuivi intentionnellement un peu au-delà du strict nécessaire de manière à éliminer les résidus de cette couche sur la surface de la couche de séparation 16.

On procède ensuite à l'élimination de la couche de séparation 16 par un décapage sélectif vis-à-vis du matériau de la seconde couche conductrice et vis-à-vis du matériau de la première couche conductrice qui reste intacte. La figure 3 qui correspond à ce stade des opérations indique que le plot de contact 15a en tungstène dépasse légèrement le niveau 18 de la première couche conductrice 14. La couche de séparation 16 en cobalt peut être éliminée sélectivement dans une solution contenant un mélange de trois parties d'acide chlorhydrique dilué à 30% et d'une partie d'eau oxygénée, pendant quelques minutes à la température ambiante.

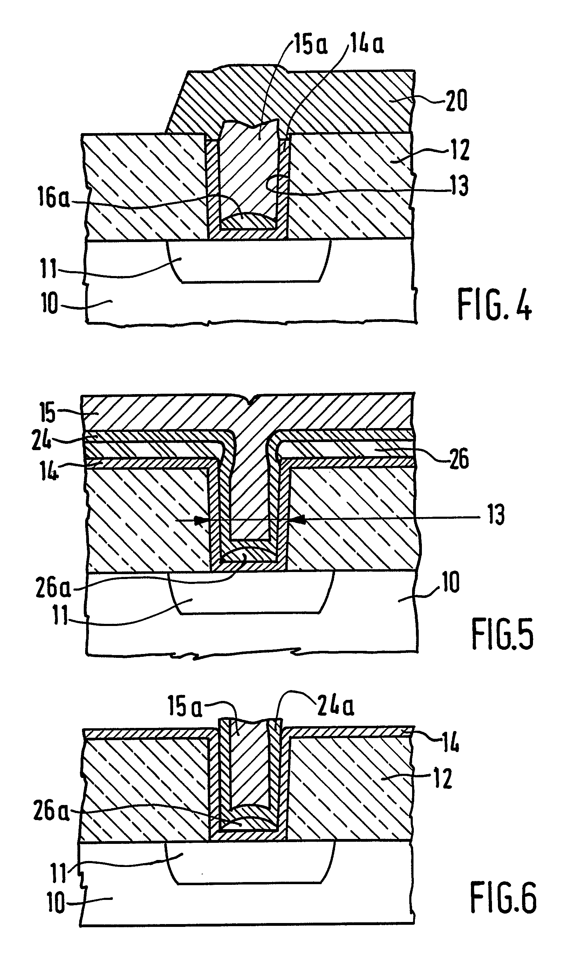

Comme indiqué à la figure 4 on procède ensuite à l'élimination de la majeure partie de la première couche conductrice pour ne conserver que les portions 14a situées à l'intérieure des ouvertures de contacts 13 après quoi on réalise une configuration d'interconnexion métallique dont une portion est représentée en 20, portion qui est en contact avec le plot de contact 14a, 15a. La configuration d'interconnexion 20 est obtenue de manière connue en soi par exemple par une couche d'un alliage d'aluminium-silicium d'une épaisseur comprise entre 0,5 et 1,5μm recouvrant l'ensemble du dispositif et dans laquelle la configuration désirée est découpée par photolithographie et décapage sélectif.

Le procédé selon l'invention permet d'ajuster le niveau du plot de contact 15a par rapport au niveau supérieur de la couche isolante 12 ce qui est aisément réalisé par un choix judicieux de l'épaisseur de la couche de séparation.

Comme il a été représenté à la figure 4, les meilleures caractéristiques électriques sont obtenues lorsque les plots de contact 15a sont légèrement proéminents par rapport au niveau de la surface de la couche isolante 12. De la sorte la liaison entre les plots de contacts 15a et la configuration d'interconnexion 20 présente à la fois la résistance la plus faible et une bonne durabilité.

En liaison avec les figures 5, 6 et 7 on va décrire une variante du procédé selon l'invention.

Dans ces figures les éléments correspondants aux figures 1 à 4 et ayant la même fonction sont affectés de repères numériques identiques. Après formation des zones actives du dispositif, les étapes consistant à déposer une couche isolante 12 à y créer des ouvertures de contacts 13 puis à recouvrir toute la surface d'une première couche conductrice 14, sont identiques à celles décrites à propos de la figure 1.

On procède alors au dépôt d'une couche de séparation 26 qui est ici réalisée en un alliage d'aluminium-silicium d'une épaisseur de 100nm. Ici à nouveau, tel qu'indiqué sur la figure 5, il n'est pas nécessaire que la couche de séparation 26 réalise un recouvrement continu de la première couche conductrice à l'intérieur des ouvertures de contacts 13. La couche de séparation 16 peut donc être réalisée par toute méthode souhaitée par exemple évaporation sous vide, pulvérisation cathodique, ou dépôt par réaction chimique activée par un plasma.

L'aluminium ou un alliage riche en aluminium est un matériau favorable pour constituer la couche de séparation 26 puisque d'une part, il peut être décapé sélectivement par rapport au tungstène constituant la seconde couche conductrice 15 et que d'autre part, il résiste au décapage effectué lorsqu'on retire cette seconde couche conductrice.

Toutefois, lorsqu'on utilise la méthode de dépôt en phase vapeur à pression réduite, pour déposer la seconde couche conductrice en tungstène 15, réaction qui utilise la réduction de l'hexafluorure de tungstène ($WF_6$) par l'hydrogène, il se dégage une quantité importante de fluor au cours de cette réaction ce qui a l'inconvénient de former avec l'aluminium un composé non volatile, électriquement résistant. Une variante du procédé selon l'invention, consiste donc à recouvrir la couche de séparation 26 par une couche barrière 24 relativement mince, en utilisant de préférence le même matériau que celui de la première couche conductrice 14. Dans l'exemple la couche barrière 24 est réalisée en alliage titane-tungstène, d'une épaisseur de 50nm et est obtenue de la même manière que la première couche conductrice 14, c'est-à-dire par pulvérisation cathodique. La seconde couche conductrice 15 en tungstène peut alors être réalisée par dépôt chimique en phase vapeur sous pression réduite utilisant la réduction de l'hexafluorure de tungstène par l'hydrogène. Elle est suffisamment épaisse pour qu'elle réalise le remplissage des ouvertures de contacts 13.

De même que pour la première couche conductrice 14, la couche barrière 24 est réalisée par une méthode assurant un fort pouvoir couvrant de sorte que la couche de séparation 26 ainsi que l'îlot 26a de cette couche situé dans le fond de l'ouverture de contact 13, sont entièrement recouverts par la couche barrière. Cette couche protège d'une attaque de l'aluminium de la couche de séparation 26 par le fluor au début du dépôt de la seconde couche conductrice 15.

On retire ensuite l'essentiel de la seconde couche conductrice 15 ainsi que la couche barrière 24 pour ne conserver ces matériaux qu'à l'intérieur des ouvertures de contacts 13. Ce décapage est effectué dans un plasma de $SF_6$ qui attaque le tungstène et l'alliage titane-tungstène successivement et pratiquement à la même vitesse.

A la fin de cette opération la couche de séparation 26 joue le rôle d'arrêt de décapage. Cette couche est ensuite décapée sélectivement en utilisant soit une méthode de décapage par voie humide utilisant une solution à base d'acide orthophosphorique, soit par voie sèche dans un plasma utilisant un composé riche en chlore, $BCl_3$ ou $CCl_3$ par exemple.

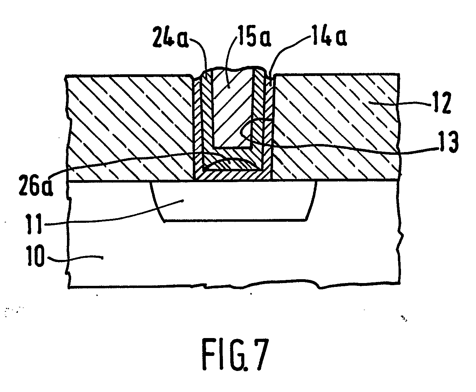

Le dispositif à ce stade des opérations se présente tel qu'indiqué à la figure 6. Selon cette variante du procédé, le décapage sélectif de la couche de séparation 26 est également utilisé pour obtenir un décalage du niveau des éléments localisés 15a de la seconde couche conductrice et 24a de la couche barrière par rapport au niveau de la première couche conductrice 14. Enfin la majeure partie de la première couche conductrice 14 est éliminée au dessus de la couche isolante 12 pour ne conserver que des éléments localisés 14a (voir figure 7) de cette première couche conductrice à l'intérieur des ouvertures de contacts 13. Ce décapage, qui est réalisé de manière non localisée, conserve le dépassement de niveau des éléments localisés 15a et 24a et permet donc comme indiqué à la figure 7 de former dans les ouvertures de contacts 13 des plots de contacts constitués des éléments 15a, 24a, 14a et 26a dont le niveau supérieur est en majeure partie aligné et de préférence surélevé par rapport au niveau de la surface de la couche isolante 12.

Le dispositif est ensuite complété en réalisant une configuration d'interconnexion métallique par exemple au moyen d'un couche relativement épaisse d'un alliage d'aluminium qui est ensuite découpée par décapage localisé dans la configuration recherchée. Ces opérations, non représentées, sont semblables à celles décrites à propos du précédent mode de réalisation de l'invention.

L'emploi mentionné dans les exemples précédents de l'aluminium ou du cobalt en tant que matériaux de base pour former la couche de séparation est avantageux car il permet à la couche de séparation de jouer un rôle d'arrêt de décapage au cours du retrait de la seconde couche conductrice ou de la couche barrière. On peut cependant utiliser tout autre matériau à la condition d'une part qu'il soit bon conducteur de l'électricité puisqu'une partie 16a ou 26a se trouve incluse dans la liaison de contact, et que d'autre part cette couche barrière puisse être décapée sélectivement par rapport au matériau de la seconde couche conductrice. Bien entendu il y aura lieu de tenir compte dans le choix de l'épaisseur de la couche de séparation 16,26 de la partie de cette couche qui sera attaquée à la fin de l'opération d'enlèvement de la seconde couche conductrice ou de l'enlèvement de la couche barrière, lorsque la couche de séparation n'offre pas une résistance totale au décapage pendant cette opération. Comme la couche de séparation est décapée à son tour sélectivement par rapport à la première couche conductrice et par rapport à la seconde couche conductrice, elle présente une solution efficace aux problèmes éventuels de transmission de la rugosité de surface de la seconde couche conductrice vers la couche isolante, fréquemment rencontrés au cours de l'opération d'élimination des couches conductrices. Il est à noter enfin que la première couche conductrice 14 peut, si nécessaire, assurer une fonction supplémentaire que celle d'adhérence et de contact à faible résistance. En effet, lorsque la couche de séparation 16, 26 est d'une nature peu compatible avec le matériau du dispositif à la surface duquel doit être réalisé le contact, il est en général facile de sélectionner la nature de la première couche conductrice 14 de telle sorte qu'elle constitue également une couche barrière, vis-à-vis de la couche de séparation. C'est le cas, par exemple, de l'alliage Ti-W qui constitue une barrière efficace vis-à-vis d'une couche de séparation en aluminium, qui, en contact direct avec le silicium, serait susceptible de provoquer une attaque préjudiciable de ce dernier.

## Revendications

1. Procédé pour établir des contacts électriques de petites dimensions sur un dispositif semiconducteur selon lequel, après avoir gravé des ouvertures de contact dans une couche isolante recouvrant le dispositif, on dépose successivement sur l'ensemble de la surface du dispositif et en utilisant une méthode assurant un fort pouvoir couvrant, une première couche conductrice relativement mince, pour former contact avec le corps semiconducteur et adhérer à la couche isolante, puis une seconde couche conductrice suffisamment épaisse pour compléter le remplissage des ouvertures de contact, après quoi on retire le matériau des couches conductrices pour dégager la surface de la couche isolante mais on le conserve dans les ouvertures de contact où il forme des plots de contact localisés qui sont ensuite reliés à une configuration d'interconnexion métallique dont on les recouvre,

caractérisé en ce qu'après avoir déposé la première couche conductrice on effectue le dépôt d'une couche dite de séparation, relativement mince, constituée d'un matériau conducteur qui peut être décapé sélectivement par rapport au matériau de la seconde couche conductrice, et en ce qu'on procède au décapage sélectif de la part essentielle de cette couche de séparation qui est située en dehors des ouvertures de contact lors de la phase ultérieure du procédé visant à dégager la surface de la couche isolante.

2. Procédé selon la revendication 1, caractérisé en ce que la couche de séparation est constituée d'un matériau choisi également pour résister au décapage effectué lors du retrait de la seconde couche conductrice de manière à servir de couche d'arrêt lors de cette opération.

3. Procédé selon la revendication 1, caractérisé en ce qu'entre le dépôt de la couche de séparation et le dépôt de la seconde couche conductrice, on effectue en outre le dépôt d'une couche barrière, relativement mince, de même matériau que celui de la première couche conductrice, en ce que la couche de séparation est constituée d'un matériau choisi pour résister au décapage effectué lors du retrait de la couche barrière, de manière à servir de couche d'arrêt lors de cette opération.

4. Procédé selon l'une quelconque des revendications 1 à 3, caractérisé en ce que les première et seconde couches de contact étant respectivement réalisées en un alliage riche en tungstène pour la première, et en tungstène pour la seconde, on choisit l'aluminium, le cobalt, ou un de leurs alliages pour constituer la couche de séparation.

5. Procédé selon l'une quelconque des revendications 1 à 4, caractérisé en ce que l'épaisseur nominale de la couche de séparation a une valeur choisie entre le 1/4 et le 1/15ième de la plus petite dimension latérale des ouvertures de contact.

FIG.1

FIG.2

FIG.3

1-Ⅲ-PHQ 88-011

15a  14a

20

12

13

16a

11

10

FIG. 4

15

24

14

26

13

26a

11

10

FIG.5

15 a                24a

14

26a

12

11

10

FIG.6

FIG. 7

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | PROCEEDINGS OF THE 1987 VLSI MULTILEVEL INTERCONNECTION CONFERENCE, Santa Clare, California, 15th - 16th juin 1987, pages 193-199, IEEE, New York, US; J.-J. LEE et al.: "A study of tungsten etchback for contact and via fill apllications" * En entier * | 1 | H 01 L 21/60<br>H 01 L 21/90<br>H 01 L 23/50 |
| A | IDEM ----- | 4,5 | |

DOMAINES TECHNIQUES
RECHERCHES (Int. Cl.4)

H 01 L

Le présent rapport a été établi pour toutes les revendications

| Lieu de la recherche | Date d'achèvement de la recherche | Examinateur |
|---|---|---|
| LA HAYE | 10-07-1989 | PHEASANT N.J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

EPO FORM 1503 03.82 (P0402)